# EUROPÄISCHE PATENTSCHRIFT

(11) **EP 0 645 637 B1**
(45) Veröffentlichungstag und Bekanntmachung des Hinweises auf die Patenterteilung: **13.11.2002**
(21) Anmeldenummer: 94112685.6
(22) Anmeldetag: 13.08.1994
(51) Int. Cl.: G01R 23/15, H03K 5/153, G06F 1/24, G01R 19/165

(54) **Schaltungsanordnung zur Erzeugung von Impulsen**
Circuit for generating pulses
Circuit de génération d'impulsions

(30) Priorität: 24.09.1993 DE 4332481
(43) Veröffentlichungstag der Anmeldung: 29.03.1995
(73) Patentinhaber: ROBERT BOSCH GMBH, 70442 Stuttgart (DE)
(72) Erfinder: Berling, Claude, Dipl.-Ing., F-67410 Drusenheim (FR)

(56) Entgegenhaltungen:
- WO-A-90/03602
- DE-A- 3 106 869
- DE-A- 3 240 707
- FR-A- 2 490 829
- US-A- 4 541 050
- PATENT ABSTRACTS OF JAPAN vol. 8 no. 60 (P-262) ,22.März 1984 & JP-A-58 211255 (MITSUBISHI DENKI) 8.Dezember 1983,

## Beschreibung

### Stand der Technik

Die Erfindung geht aus von einer Schaltungsanordnung zur Erzeugung von Impulsen nach der Gattung des Hauptanspruchs. Aus der DE-PS 30 35 896 ist eine gattungsgemäße Schaltungsanordnung bekannt, die Rücksetzimpulse für Zähler oder für Mikroprozessoren erzeugt. Rücksetzimpulse werden abgegeben, wenn ein an einem Eingang der Schaltungsanordnung liegendes, zu überwachendes Wechselspannungssignal ausbleibt. Die Schaltungsanordnung schwingt auf einer vorgegebenen Frequenz und stellt am Ausgang eines Komparators ein impulsförmiges Signal bereit, das als Rücksetzsignal verwendbar ist. Der Schwingvorgang ist mit einem Schalttransistor unterbindbar, der den Kondensator mit einer Schaltungsmasse verbindet. Der Schalttransistor wird von dem zu überwachenden Signal angesteuert, das zur Abtrennung eines Gleichspannungspegels über eine Hochpaßanordnung geführt ist. Das impulsförmige Signal am Ausgang des Komparators tritt auf, wenn die Frequenz des zu überwachenden Signals unter die von der Hochpaßanordnung vorgegebene Grenzfrequenz absinkt.

Aus der US-A 4,541,050 ist eine Schaltungsanordnung bekannt geworden, die Rücksetzimpulse für einen Mikrocomputer bereitstellt in Abhängigkeit von einem Ausgangssignal des Mikrocomputers. Die Schaltungsanordnung enthält Komparatoren, die jeweils eine an einem Kondensator auftretende Spannung mit einem vorgegebenen Schwellenwert vergleichen. Die Spannung an den Kondensatoren kann jeweils mit einem Transistor beeinflusst werden, der über eine Hochpass-Filterschaltung mit dem vom Mikrocomputer bereitgestellten Signal beaufschlagt wird. Die Transistoren schliessen die Kondensatoren gegen eine elektrische Schaltungsmasse kurz unter der Voraussetzung, dass das vom Mikrocomputer bereitgestellte Signal die Hochpass-Filterschaltungen jeweils passieren kann.

Der Erfindung liegt die Aufgabe zugrunde, eine kostengünstige Schaltungsanordnung anzugeben, die Impulse erzeugt, wenn ein zu überwachendes Signal unter eine untere Grenzfrequenz absinkt oder über eine obere Grenzfrequenz ansteigt.

Die Aufgabe wird durch die im unabhängigen Anspruch angegebenen Merkmale gelöst.

### Vorteile der Erfindung

Die erfindungsgemäße Schaltungsanordnung weist den Vorteil auf, dass mit wenigen Standardbauelementen die Überwachung eines Signals auf das Unterschreiten einer unteren und auf das Überschreiten einer oberen Grenzfrequenz möglich ist.

Die untere Grenzfrequenz wird mit der aus dem Stand der Technik bekannten Hochpass-Filterschaltung vorgegeben. Die obere Grenzfrequenz wird durch eine erfindungsgemäße Beschaltung eines Schalttransistors eingestellt. Vorgesehen ist ein Widerstand, der in Reihe zur Schaltstrecke des Schalttransistors liegt. Die obere Grenze der Schaltfrequenz des Schalttransistors wird damit auf einen vorgegebenen Wert begrenzt, der der vorgegebenen oberen Grenzfrequenz des zu überwachenden Signals entspricht. Durch die gezielte Begrenzung der maximal möglichen Schaltfrequenz des Schalttransistors werden zusätzliche Bauelemente, die zur Realisierung einer Tiefpass-Funktion erforderlich wären, eingespart.

Der Widerstand erfüllt zusätzlich eine Schutzfunktion für den Schalttransistor gegenüber unzulässig hohen Strömen in der Schaltstrecke, die ohne diesen Widerstand auftreten könnten, sofern Leitungswiderstände oder der Innenwiderstand des Kondensators nicht ausreichen.

Vorteilhafte Weiterbildungen und Ausgestaltungen der erfindungsgemäßen Schaltungsanordnung zur Erzeugung von Impulsen ergeben sich aus abhängigen Ansprüchen.

Eine vorteilhafte Ausgestaltung sieht eine Rückkopplung in der Schaltungsanordnung vor, die zu einem Schwingen der Schaltungsanordnung führt, wenn das zu überwachende Signal außerhalb der vorgegebenen Grenzen liegt. Der Vorteil dieser Maßnahme liegt darin, dass in diesem Betriebszustand je nach Beschaltung entweder eine Impulsfolge oder ein rechteckförmiges Signal so lange abgegeben wird, bis das zu überwachende Signal innerhalb der vorgegebenen Grenzen liegt.

Die erfindungsgemäße Schaltungsanordnung wird vorzugsweise ergänzt durch eine Überwachungsschaltung einer Versorgungsspannung. Der Ausgang einer solchen Spannungsüberwachungsschaltung kann bei einer speziellen Auslegung der Endstufenschaltungen sowohl des Komparators als auch der Überwachungsschaltung als Open-Collektor-Ausgänge zusammengeschaltet werden, um eine Wired-OR-Verknüpfung zu realisieren.

Weitere vorteilhafte Weiterbildungen und Ausgestaltungen ergeben sich aus weiteren Unteransprüchen in Verbindung mit der folgenden Beschreibung.

### Zeichnung

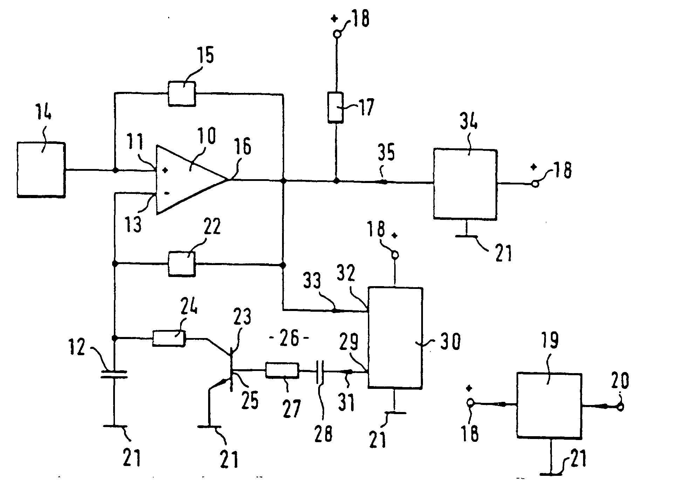

In der Figur ist ein Schaltbild einer erfindungsgemäßen Schaltungsanordnung zur Erzeugung von Impulsen gezeigt.

Die erfindungsgemäße Schaltungsanordnung enthält einen Komparator 10, der eine an einem nichtinvertierenden Eingang 11 liegende Schwellenspannung mit einer an einem Kondensator 12 abgreifbaren Spannung vergleicht, die einem invertierenden Eingang 13 des Komparators 10 zugeleitet ist. Die am nichtinvertierenden Eingang 11 liegende Schwellenspannung wird einerseits von einem Referenzspannungsgenerator 14 und andererseits von einem Mitkopplungswiderstand 15 festgelegt. Der Mitkopplungswiderstand 15 verbindet den nichtinvertierenden Eingang 11 mit einem Ausgang 16 des Komparators 10.

Der Ausgang 16 ist über einen Arbeitswiderstand 17 mit einem positiven Pol 18 einer Energieversorgung 19 verbunden. Die Energieversorgung 19 stellt am positiven Pol 18 eine, gegebenenfalls stabilisierte, Spannung bereit, die aus einer Eingangsspannung 20 gewonnen wird. Sowohl die Eingangsspannung 20 als auch die Spannung am positiven Pol 18 sind bezogen auf eine Masse 21.

Zwischen dem Ausgang 16 des Komparators 10 und seinem invertierenden Eingang 13 ist ein Gegenkopplungswiderstand 22 geschaltet. Parallel zum Kondensator 12 liegt eine Schaltstrecke eines Halbleiterschalters 23. In Reihe zur Schaltstrecke des Halbleiterschalters 23 ist ein Strombegrenzungswiderstand 24 geschaltet. Ein Steuereingang 25 des Halbleiterschalters 23 ist über eine Hochpaßanordnung 26, die einen Widerstand 27 und einen Kondensator 28 enthält, mit einem Ausgang 29 eines Mikroprozessors 30 verbunden. Der Mikroprozessor 30 gibt am Ausgang 29 ein zu überwachendes Signal 31 an die Hochpaßanordnung 26 ab. Der Ausgang 16 des Komparators 10 ist mit einem Rücksetzeingang 32 des Mikroprozessors 30 verbunden. Am Rücksetzeingang 32 tritt ein Rücksetzsignal 33 auf.

Eine Spannungsüberwachungsschaltung 34 überwacht die am positiven Pol 18 liegende Spannung der Schaltungsanordnung und gibt bei Abweichungen von einem Sollwert ein Ausgangssignal 35 ab, das im gezeigten Ausführungsbeispiel identisch mit dem Rücksetzsignal 33 ist.

Die erfindungsgemäße Schaltungsanordnung zur Erzeugung von Impulsen arbeitet folgendermaßen:

Der Mikroprozessor 30 benötigt für ein ordnungsgemäßen Arbeiten im allgemeinen das Rücksetzsignal 33, das dem Mikroprozessor 30 über den Rücksetzeingang 32 zugeführt werden muß. Anstelle eines Mikroprozessors 30 kann auch eine Zählerschaltung oder eine andere Schaltungsanordnung vorgesehen sein, die ein Rücksetzsignal 33 benötigt. Die erfindungsgemäße Schaltungsanordnung erzeugt am Ausgang 16 des Komparators 10 ein impulsförmiges oder rechteckiges Rücksetzsignal, das als Reset-Signal 33 verwendet wird.

Der Komparator 10 wirkt in Verbindung mit dem Referenzspannungsgenerator 14, dem Mitkopplungswiderstand 15, dem Kondensator 12 und dem Gegenkopplungswiderstand 22 als Oszillatorschaltung. Der Komparator 10 vergleicht die am Kondensator 12 abgreifbare Spannung, die an den invertierenden Eingang 13 geführt ist, mit der am nichtinvertierenden Eingang 11 liegenden Schwellenspannung, die vom Referenzspannungsgenerator 14 und vom Mitkopplungswiderstand 15 gemeinsam festgelegt wird. Der Mitkopplungswiderstand 15 verleiht dem Komparator 10 eine Hysterese, die in Abhängigkeit vom gerade vorliegenden Signalpegel am Ausgang 16 die Schwellenspannung am nicht invertierenden Eingang 11 nach oben oder nach unten verschiebt.

Die am Kondensator 12 abgreifbare Spannung kann mit dem Halbleiterschalter 23, vorzugsweise ein Schalttransistor in Bipolar- oder Feldeffekttechnik, beeinflußt werden. In Abhängigkeit von der am Steuereingang 25 liegenden Spannung wird der Kondensator 12 über den Strombegrenzungswiderstand 24 gegen Masse 21 kurzgeschlossen. In einer alternativen Ausführung ist es auch möglich, den Kondensator 12 an den Pluspol 18 zu schalten. Anstelle des im Ausführungsbeispiel eingetragenen Schalttransistors in npn-Struktur ist dann eine pnp-Struktur erforderlich. Bei den pnp-Strukturen ist es besonders einfach möglich, ein impulsförmiges Rücksetzsignal zu erzeugen. Damit wird erreicht, daß der Mikroprozessor 30 präzise anlaufen kann. Eine untere Grenze bei der Festlegung des Widerstandswertes für den Strombegrenzungswiderstand 24 ist durch den maximal zulässigen Strom im Halbleiterschalter 23 gegeben.

Das am Steuereingang 25 des Halbleiterschalters 23 liegende Signal ist das über die Hochpaßanordnung 26 geleitete, zu überwachende Signal 31, das der Mikroprozessor 30 am Ausgang 29 bereitstellt. Das zu überwachende Signal 31 ermöglicht die Überwachung des Mikroprozessors 30 auf ordnungsgemäßes Arbeiten. Die erfindungsgemäße Schaltungsanordnung ermöglicht nun eine Überwachung daraufhin, ob das zu überwachende Signal 31 eine untere Frequenzgrenze unter oder eine obere Frequenzgrenze überschreitet. Das Unterschreiten der unteren Frequenzgrenze hat zur Folge, daß das zu überwachende Signal 31 die Hochpaßanordnung 26 nicht mehr passieren kann. Die Grenzfrequenz der Hochpaßanordnung 26 ist auf einen Wert festzulegen, bei dessem Erreichen ein Durchschalten des Halbleiterschalters 23 nicht mehr möglich ist.

Die Hochpaßanordnung 26 ist in besonders einfacher Weise mit einer Reihenschaltung aus dem Kondensator 28 und dem Widerstand 27 realisierbar.

Anstelle einer Tiefpaßanordnung, die zur Festlegung einer oberen Grenzfrequenz für das zu überwachende Signal 31 vorgesehen ist, die mit diskreten Bauelementen zu realisieren wäre, wird in der erfindungsgemäßen Schaltungsanordnung die Schaltgeschwindigkeit des Halbleiterschalters 23 gezielt herabgesetzt, um die obere Grenzfrequenz festzulegen. Dieses Ziel kann beispielsweise durch eine hochohmige Auslegung der Ansteuerung erreicht werden. Besonders vorteilhaft ist die Realisierung der Hochpaßanordnung 26 mit dem Widerstand 27, der gleichzeitig dazu herangezogen wird, die hochohmige Auslegung zu realisieren. Bei der Berechnung der unteren Grenzfrequenz der Hochpaßanordnung 26 ist deshalb zunächst der Wert des Widerstands 27 und danach der Wert des Kondensators 28 festzulegen.

Die hochohmige Auslegung des Widerstands 27 verlangsamt die Umladung von parasitären Kapazitäten, die der Halbleiterschalter 23 stets aufweist. Bei einem Bipolartransistor tritt insbesondere die zwischen dem Kollektor und der Basis liegende parasitäre Kapazität in Erscheinung. Bei einer Feldeffektstruktur dominiert die Gatekapazität. Andere Halbleiterstrukturen, die gegebenenfalls als Halbleiterschalter 23 eingesetzt werden, weisen ebenfalls stets parasitäre Kapazitäten auf, die während des Schaltvorgangs umgeladen werden müssen. Eine hochohmige Auslegung des Widerstands 27 reduziert die Umladegeschwindigkeit der parasitären Kapazitäten und verringert somit die Schaltgeschwindigkeit des Halbleiterschalters 23. In einer realisierten Schaltung wurde der Widerstand 27 auf einen Wert von 100 Kiloohm festgelegt. Die Schaltfrequenz des Halbleiterschalters 23, ein Niederfrequenz-Bipolartransistor, konnte mit diesem Wert auf einen Wert im Kilohertz-Bereich festgelegt werden.

Eine andere Maßnahme, die gegebenenfalls zusätzlich vorgesehen ist, bietet die vergleichsweise hochohmige Auslegung des Strombegrenzungswiderstands 24. Der Strombegrenzungswiderstand 24, dessen Widerstandswert üblicherweise bei einigen 100 Ohm oder wenige Kiloohm beträgt, wird auf einen Wert von oberhalb 10 Kiloohm bis einigen Hundert Kiloohm erhöht. Bei einer Einbeziehung des Strombegrenzungswiderstands 24 zur Verringerung der Schaltgeschwindigkeit des Halbleiterschalters 23 ist zu berücksichtigen, daß die Entladedauer des Kondensators 12 zunimmt.

Die erfindungsgemäße Schaltungsanordnung wird vorzugsweise durch die Spannungsüberwachungsschaltung 34 ergänzt, welche die am Pluspol 13 liegende Spannung auf korrekte Einhaltung eines vorgegebenen Werts überwacht. Bei Abweichungen vom Sollwert wird das Ausgangssignal 35 abgegeben, das vorzugsweise identisch mit dem Rücksetzsignal 33 ist. Im gezeigten Ausführungsbeispiel ist das Ausgangssignal 35 unmittelbar mit dem Ausgang 16 des Komparators 10 verbunden. Eine spezielle Ausgestaltung der im Komparator 10 und in der Spannungsüberwachungsschaltung 34 enthaltenen Endstufenschaltungen als Open-Collektor-Ausgänge ermöglicht die gezeigte Wired-OR-Schaltung, die den Arbeitswiderstand 17 enthält.

Die erfindungsgemäße Schaltungsanordnung läßt sich mit wenigen Bauelementen kostengünstig realisieren. Die Industrie bietet integrierte Schaltkreise an, die einen Teil der Schaltfunktionen enthält, die in der Figur gezeigt sind. Beispielsweise ist unter der Bezeichnung L4949 von der Firma SGS-THOMSON eine integrierte Schaltung erhältlich, die die Energieversorgung 19 zum Bereitstellen einer (stabilisierten) Spannung 18, die Spannungsüberwachungsschaltung 34, den Komparator 10 sowie den Referenzspannungsgenerator 14 enthält. Zur Realisierung der erfindungsgemäßen Schaltungsanordnung werden dann im wesentlichen nur noch der Kondensator 12, der Halbleiterschalter 23 sowie die Hochpaßanordnung 26 mit der speziellen Dimensionierung des Widerstands 27 benötigt.

## Patentansprüche

1. Schaltungsanordnung zur Erzeugung von Impulsen, insbesondere Rücksetzimpulse für Zähler oder Mikroprozessoren (30), mit einem Komparator (10), der eine an einem Kondensator (12) abgreifbare Spannung mit einem vorgegebenen Schwellenwert vergleicht, und mit einem Schalttransistor (23) zum Beeinflussen der Kondensatorspannung, dessen Steuereingang (25) mit einer Hochpaßanordnung (26) verbunden und von einem zu überwachenden Signal (31) angesteuert ist, **dadurch gekennzeichnet, dass** ein Widerstand (24) in Reihe zur Schaltstrecke des Schaltertransistors (23) an dessen Kollektor liegt, und die Dimensionierung des Widerstands (24) die obere Grenze der Schaltfrequenz des Schalttransistor (23) auf einen vorgegebenen Wert begrenzt, der einer vorgegebenen maximal zulässigen Frequenz des zu überwachenden Signals (31) entspricht.

2. Schaltungsanordnung nach Anspruch 1, **dadurch gekennzeichnet, daß** als Schalttransistor ein Transistor vorgesehen ist, dessen Basis oder Gateanschluß über einen weiteren ohmschen Widerstand (27) mit dem zu überwachenden Signal (31) verbunden ist.

3. Schaltungsanordnung nach einem der Anspruche 1 oder 2, **dadurch gekennzeichnet, daß** die Schaltungsanordnung die erzeugten Impulse als periodische Impulsfolge abgibt, wenn das zu überwachende Signal (31) eine vorgegebene Grenzfrequenz unter- oder überschreitet.

4. Schaltungsanordnung nach einem der Anspruche 1 bis 3, **dadurch gekennzeichnet, daß** eine Spannungsüberwachungsschaltung (34) vorgesehen ist, die ein Ausgangssignal (35) abgibt, das den erzeugten Impulsen überlagert ist.

5. Schaltungsanordnung nach einem der Anspruche 2 bis 4, **dadurch gekennzeichnet, daß** der weitere Widerstand (27) ein Teil der Hochpaßanordnung (26) ist, die den weiteren Widerstand (27) und einen Kondensator (28) enthält.

## Claims

1. Circuit arrangement for producing pulses, particularly reset pulses for counters or microprocessors (30), having a comparator (10) which compares a voltage which can be tapped off on a capacitor (12) with a prescribed threshold value, and having a switching transistor (23) for influencing the capacitor voltage, whose control input (25) is connected to a high-pass filter arrangement (26) and is driven by a signal (31) which is to be monitored, **characterized in that** a resistor (24) is connected in series with the switching path of the switching transistor (23) to the latter's collector, and the dimensioning of the resistor (24) limits the upper limit of the switching frequency of the switching transistor (23) to a prescribed value which corresponds to a prescribed maximum permissible frequency of the signal (31) to be monitored.

2. Circuit arrangement according to Claim 1, **characterized in that** the switching transistor provided is a transistor whose base connection or gate connection is connected via a further nonreactive resistor (27) to the signal (31) to be monitored.

3. Circuit arrangement according to one of Claims 1 or 2, **characterized in that** the circuit arrangement outputs the produced signals as a periodic pulse train if the signal (31) to be monitored falls below or exceeds a prescribed cut-off frequency.

4. Circuit arrangement according to one of Claims 1 to 3, **characterized in that** a voltage monitoring circuit (34) is provided which outputs an output signal (35) which overlies the produced pulses.

5. Circuit arrangement according to one of Claims 2 to 4, **characterized in that** the further resistor (27) is part of the high-pass filter arrangement (26) which contains the further resistor (27) and a capacitor (28).

## Revendications

1. Circuit pour créer des impulsions notamment des impulsions de remise à l'état initial de compteurs ou de microprocesseurs (30) comprenant un comparateur (10) qui compare une tension prise aux bornes d'un condensateur (12) à un seuil prédéterminé et un transistor de commutation (23) pour influencer la tension du condensateur et dont l'entrée de commande (25) est reliée à un dispositif passe-haut (26) et est commandée par un signal (31) à surveiller,
**caractérisé en ce qu'**
une résistance (24) est branchée en série sur le circuit de commutation du transistor de commutation (23) à son collecteur, et le dimensionnement de la résistance (24) fixe la limite supérieure de la fréquence de commutation du transistor de commutation (23), à une valeur prédéterminée qui correspond à une fréquence maximale autorisée, prédéterminée du signal à surveiller (31).

2. Circuit selon la revendication 1,
**caractérisé en ce que**
le transistor de commutation est un transistor dont la borne de base ou de porte est reliée par une autre résistance ohmique (27) au signal (31) à surveiller.

3. Circuit selon l'une quelconque des revendications 1 ou 2,
**caractérisé en ce qu'**
il génère les impulsions comme suites d'impulsions périodiques si le signal (31) à surveiller dépasse une fréquence unique prédéterminée, vers le haut ou vers le bas.

4. Circuit selon l'une quelconque des revendications 1 à 3,
**caractérisé par**
un circuit de surveillance de tension (34) qui émet un signal de sortie (35) combiné aux impulsions générées.

5. Circuit selon l'une quelconque des revendications 2 à 4,
**caractérisé en ce que**
l'autre résistance (27) fait partie du dispositifs passe-haut (26) comprenant l'autre résistance (27) et un condensateur (28).
